# EUROPEAN PATENT SPECIFICATION

(11) **EP 4 160 705 B1**
(45) Date of publication and mention of the grant of the patent: **06.05.2026**
(21) Application number: 21812397.4
(22) Date of filing: 18.05.2021
(51) Int. Cl.: G02B 6/42, H01S 5/022

(54) **OPTICAL WAVEGUIDE PACKAGE AND LIGHT EMITTING DEVICE**
LICHTWELLENLEITERGEHÄUSE UND LICHTEMITTIERENDE VORRICHTUNG
BOÎTIER DE GUIDE D'ONDE OPTIQUE ET DISPOSITIF ÉLECTROLUMINESCENT

(30) Priority: 29.05.2020 JP 2020094753
(43) Date of publication of application: 05.04.2023
(73) Proprietor: Kyocera Corporation, Kyoto-shi Kyoto 612-8501 (JP)
(72) Inventor: ITAKURA, Yoshiaki, Kyoto-shi, Kyoto 612-8501 (JP)
(74) Representative: Viering, Jentschura & Partner mbB Patent- und Rechtsanwälte
(86) International application number: PCT/JP2021/018825
(87) International publication number: WO 2021/241332

(56) References cited:
- JP-A- 2007 328 201
- JP-A- 2019 195 097
- JP-A- H0 961 651
- JP-A- H10 308 555
- US-A- 5 521 992
- US-A1- 2003 123 815
- US-A1- 2015 316 734
- US-B1- 6 477 286
- US-B2- 10 663 660

## Description

### TECHNICAL FIELD

The present disclosure relates to an optical waveguide package and a light-emitting device.

### BACKGROUND OF INVENTION

A known technique is described in, for example, Patent Literature 1.

US 10 663 660 B2 discloses an optical subassembly comprising: a substrate; a waveguide disposed on the substrate, wherein the waveguide comprises a patterned stack of adjacent and discrete SiON layers, wherein the stack of adjacent and discrete SiON layers has a stress having a magnitude less than or equal to 20 MPa and an optical loss less than or equal to 1 dB/cm; an electrical interconnection layer disposed on the substrate and on the waveguide, wherein the electrical interconnection layer comprises at least an electrical interconnection line; a device disposed on the substrate and aligned to the waveguide, wherein the device comprises at least a device terminal configured to be coupled to the electrical interconnection A similar assembly is disclosed in US 5 521 992 A.

### CITATION LIST

### PATENT LITERATURE

Patent Literature 1: Japanese Patent No. 4579868

### SUMMARY

The present invention provides an optical waveguide package according to claim 1 and a light-emitting device according to claim 13. Further embodiments of the present invention are disclosed in the dependent claims.

### BRIEF DESCRIPTION OF THE DRAWINGS

The objects, features, and advantages of the present disclosure will become more apparent from the following detailed description and the drawings.
FIG. 1 is a cross-sectional view of a light-emitting device 1 including an optical waveguide package 2 according to an embodiment not according to the claimed invention.
FIG. 2 is a plan view of the light-emitting device 1.
FIG. 3 is a perspective view of the light-emitting device 1.
FIG. 4A is a cross-sectional view of a light-emitting device 1a according to an embodiment according to the claimed invention.
FIG. 4B is a plan view of the light-emitting device 1a illustrating its internal structure.
FIG. 5A is a cross-sectional view of a light-emitting device 1b according to an embodiment according to the claimed invention.
FIG. 5B is a bottom view of the light-emitting device 1b.
FIG. 6A is a cross-sectional view of a light-emitting device 1b with an example structure similar to the structure according to the the embodiment of figure 5A.
FIG. 6B is a bottom view of the light-emitting device 1b.
FIG. 7 is a partial cross-sectional view of a light-emitting device 1c according to an embodiment not according to the claimed invention.
FIG. 8A is a cross-sectional view of a light-emitting device 1d according to an embodiment according to the claimed invention.
FIG. 8B is a plan view of the light-emitting device 1d without a lid 23.
FIG. 8C is a bottom view of the light-emitting device 1d.
FIG. 9A is a cross-sectional view of a light-emitting device 1e an embodiment according to the claimed invention.
FIG. 9B is a plan view of the light-emitting device 1e without the lid 23.
FIG. 9C is a bottom view of the light-emitting device 1e.
FIG. 10A is a cross-sectional view of a light-emitting device 1f according to an eighth embodiment.
FIG. 10B is a plan view of the light-emitting device 1f without the lid 23.
FIG. 10C is a bottom view of the light-emitting device 1f.
FIG. 11A is a cross-sectional view of a light-emitting device 1g according to an embodiment according to the claimed invention.
FIG. 11B is a plan view of the light-emitting device 1g without the lid 23.
FIG. 11C is a bottom view of the light-emitting device 1g.
FIG. 12A is a cross-sectional view of a light-emitting device 1h according to an embodiment not according to the claimed invention.
FIG. 12B is a plan view of the light-emitting device 1h without the lid 23.
FIG. 12C is a bottom view of the light-emitting device 1h.
FIG. 13 is a cross-sectional view of a light-emitting device 1i according to an embodiment not according to the claimed invention.

### DESCRIPTION OF EMBODIMENTS

The structure that forms the basis of an optical waveguide package according to one or more embodiments of the present disclosure and a light-emitting device including the optical waveguide package includes an optical integrated circuit including a gas-barrier optical waveguide including a non gas-barrier core and a non gas-barrier cladding having a permeability coefficient for helium lower than or equal to 5 × 10⁻⁹ cm³(STP)mm/(cm²·sec·cmHg) (25 °C) coated with a gas-barrier thin film, a gas-barrier cap, an optical element including a light receiver or a light emitter mounted on a first surface of the optical waveguide at a position to be optically coupled to the core, and a metal wiring member on the first surface of the waveguide and direct below the thin film to be electrically connected to the optical element on the first surface of the optical waveguide.

To mount the optical waveguide and the cap on the optical integrated circuit, the thin film on the first surface of the optical waveguide and on the metal wiring member and a second surface of the cap are joined together with a gas-barrier inorganic material layer in between, without an organic material layer, to achieve gas-barrier performance. A sealed airtight space is defined by the thin film on the optical waveguide and the gas-barrier members alone. The sealed airtight space accommodates one end of the core and the optical element.

An optical waveguide package and a light-emitting device according to one or more embodiments of the present disclosure will now be described with reference to the drawings. The figures referred to below are schematic diagrams illustrating main components of the optical waveguide package and the light-emitting device for ease of illustration. The optical waveguide package and the light-emitting device may include known components not illustrated in the figures, such as circuit boards, wire conductors, control ICs, or LSIs. In the embodiments described below, the same reference numerals denote the corresponding components and will not be described repeatedly.

### First Embodiment

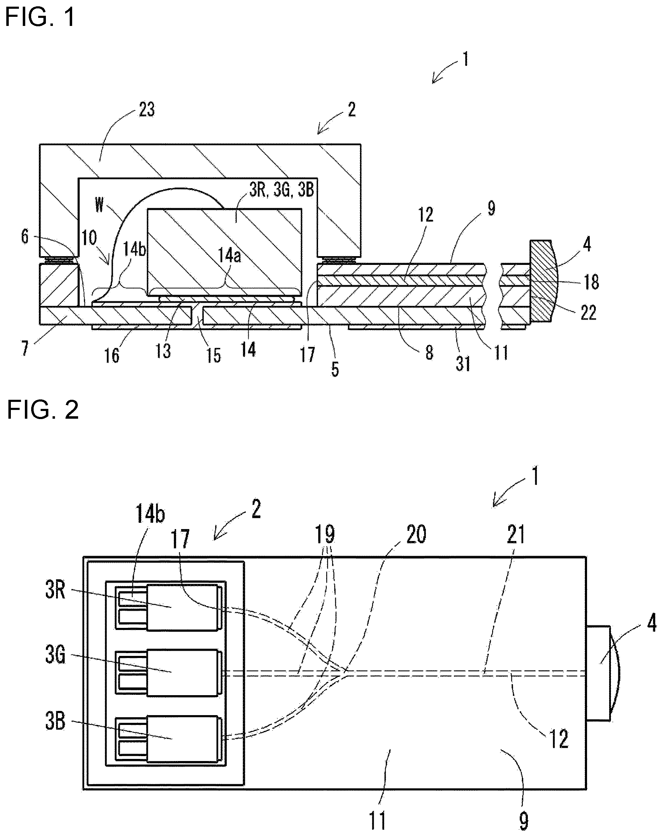

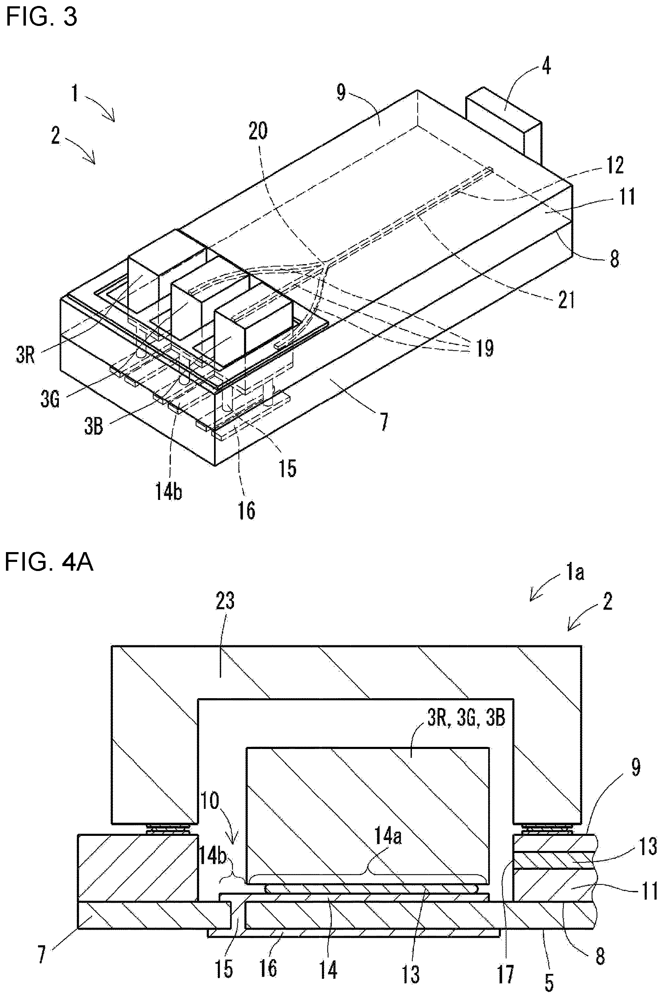

FIG. 1 is a cross-sectional view of a light-emitting device 1 including an optical waveguide package 2 according to an embodiment not according to the claimed invention. FIG. 2 is a plan view of the light-emitting device 1. FIG. 3 is a perspective view of the light-emitting device 1. In the present embodiment, the light-emitting device 1 includes the optical waveguide package 2, light-emitting elements 3R, 3G, and 3B corresponding to red, green, and blue light, and a condenser lens 4.

The optical waveguide package 2 includes a substrate 7 including a first surface 5 and a second surface 6 opposite to the first surface 5, a cladding 11 located on the second surface 6 and including a third surface 8 facing the second surface 6, a fourth surface 9 opposite to the third surface 8, and an element-receiving portion 10 with openings in the fourth surface 9, a core 12 located in the cladding 11 and extending from the element-receiving portion 10, and first metal members 14 located in the element-receiving portion 10 in a plan view as viewed in a direction toward the fourth surface 9 and each including an element mount 13.

The substrate 7 may be a ceramic board including dielectric layers made of a ceramic material. Examples of the ceramic material used for the ceramic board include sintered aluminum oxide, sintered mullite, sintered silicon carbide, sintered aluminum nitride, and sintered glass ceramic. For the substrate 7 being a ceramic board, the dielectric layers include conductors such as connection pads, internal wiring conductors, and external connection terminals for electrical connection between the light-emitting elements 3R, 3G, and 3B and an external circuit.

The substrate 7 may be an organic board including dielectric layers made of an organic material. The organic board may be a printed board, a build-up board, or a flexible board. Examples of the organic material used for the organic board include an epoxy resin, a polyimide resin, a polyester resin, an acrylic resin, a phenolic resin, and a fluororesin.

The core 12 is located in the cladding 11. The core 12 and the cladding 11 form an optical waveguide. Both the core 12 and the cladding 11 may be glass or a resin. In some embodiments, one of the core 12 and the cladding 11 may be glass, and the other may be a resin. In this case, the core 12 and the cladding 11 have different refractive indexes, or specifically, the core 12 has a higher refractive index than the cladding 11. The difference in the refractive index causes total internal reflection of light. More specifically, a material with a higher refractive index is used for an optical path, which is then surrounded by a material with a lower refractive index. This structure confines and carries light in the core 12 with the higher refractive index.

The core 12 includes multiple incident end faces 17 and one emission end face 18. The core 12 defines, between the incident end faces 17 and the emission end face 18, a merging path including multiple branching paths 19, a merging portion 20, and a joined path 21. The branching paths 19 include the corresponding incident end faces 17 at one end. The merging portion 20 merges the branching paths 19 together. The joined path 21 includes the emission end face 18 at one end.

The condenser lens 4 faces the emission end face 18 of the core 12 and a side surface 22 of the substrate 7 adjacent to the emission end face 18. The condenser lens 4 may be, for example, a lens such as a SELFOC (registered trademark) lens or a rod lens, or an optical element such as a diffraction grating. The condenser lens 4 has an optical axis aligned with the central axis of the emission end face 18. The condenser lens 4, which is an optical member, may face at least a portion of the emission end face 18 of the core 12 and the side surface 22 of the substrate 7 adjacent to the emission end face 18. In other words, the condenser lens 4 may be on an optical path of the light emitted from the core 12.

Red (R) light, green (G) light, and blue (B) light emitted from the respective light-emitting elements 3R, 3G, and 3B enter the respective branching paths 19 through the incident end faces 17 and pass through the merging portion 20 and the joined path 21 to the condenser lens 4, through which the light is condensed and emitted.

The condenser lens 4 is, for example, a plano-convex lens with a flat incident surface and a convex emission surface. The optical waveguide package 2 includes the optical waveguide, the light-emitting elements 3R, 3G, and 3B, and the condenser lens 4 assembled together to align the optical axis of each branching path 19 with the center of a light emitter in the corresponding light-emitting element 3R, 3G, or 3B.

The cladding 11 includes recesses each defined by a bottom surface and inner wall surfaces surrounding the bottom surface. The recesses serve as the element-receiving portion 10. The recesses may extend from the fourth surface 9 to the third surface 8. A lid 23 is placed to cover the element-receiving portion 10. The element-receiving portion 10 extends from the fourth surface 9 to the third surface 8. The lid 23 is a component recessed downward and is sized to cover the element-receiving portion 10 and can receive wiring members W used for wire bonding. The lid 23 may be formed by wet etching, dry etching, sandblasting, or another method.

First metal members 14 each are connected to a second metal member 16 with a first via conductor 15 extending through the substrate 7 from the first surface 5 to the second surface 6 of the substrate 7. This structure allows connection to a power supply through secondary mounting and eliminates complicated conductor stacking between the lid 23 and the cladding 11 as well as extra processes for such complicated conductor stacking. This structure also achieves electrical connection while providing sufficient airtightness and electrical insulation. The optical waveguide package 2 includes fewer junctions and leads and is thus smaller.

### Second Embodiment

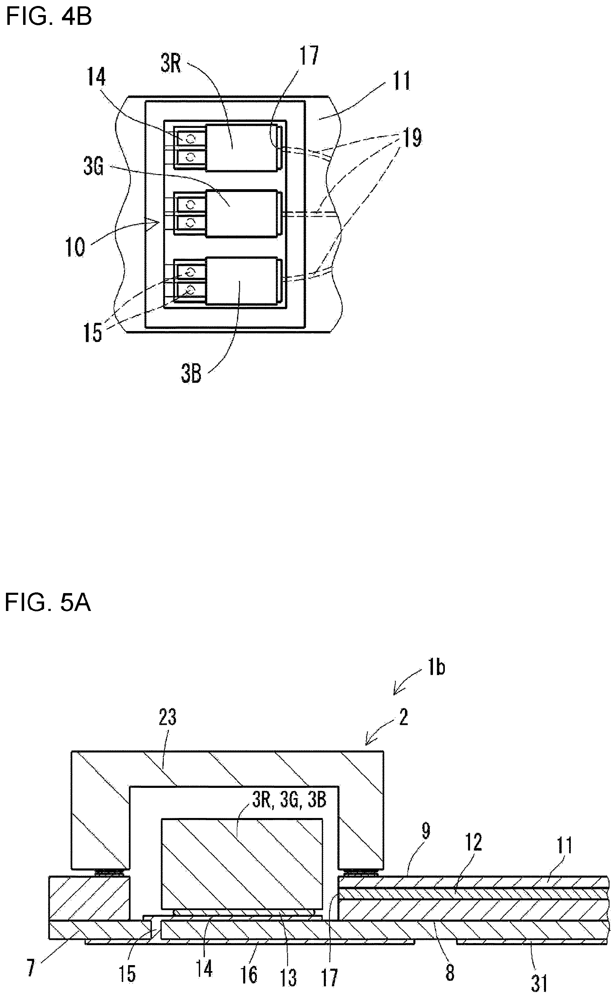

FIG. 4A is a cross-sectional view of a light-emitting device 1a according to an embodiment according to the claimed invention. FIG. 4B is a plan view of the light-emitting device 1a illustrating its internal structure. The same reference numerals denote the components corresponding to those in the above embodiment and will not be described repeatedly. In the light-emitting device 1a according to the present embodiment, each first metal member 14 includes a first area 14a, which is the element mount 13, and a second area 14b other than the first area 14a. Each first via conductor 15 is in contact with the corresponding first metal member 14 on the second area 14b.

The light-emitting elements 3R, 3G, and 3B have smaller variations in the height and the degree of tilt when the first via conductors 15 are located to avoid the first areas 14a, which are the element mounts 13, or more specifically, when the first via conductors 15 are located on the corresponding second areas 14b. A portion including a via conductor may be surrounded by a portion protruding or recessed from the surface of the substrate. However, the first via conductors 15 located to avoid the element mounts 13 allows highly accurate positioning of the light-emitting elements 3R, 3G, and 3B during mounting. Thus, the light-emitting elements 3R, 3G, and 3B each have an optical axis positioned more accurately.

### Third Embodiment

The first metal members 14 in an embodiment are located in the openings alone in a plan view as viewed in a direction toward the fourth surface 9. This structure is used for the reasons below. When the first metal members 14 extend onto the third surface 8 between the cladding 11 and the substrate 7, the light-emitting device is taller by the thickness of the metal members 14, and portions of each first metal member 14 with and without the cladding 11 are to have different thermal contraction rates. Such a difference in thermal contraction may cause deformation of the entire module, separation between the cladding 11 and the first metal members 14 or between the first metal members 14 and the substrate 7, or cracks in the cladding 11. When the first metal members 14 are located in the openings alone, the light-emitting device is less tall and may be less susceptible to thermal contraction.

### Fourth Embodiment

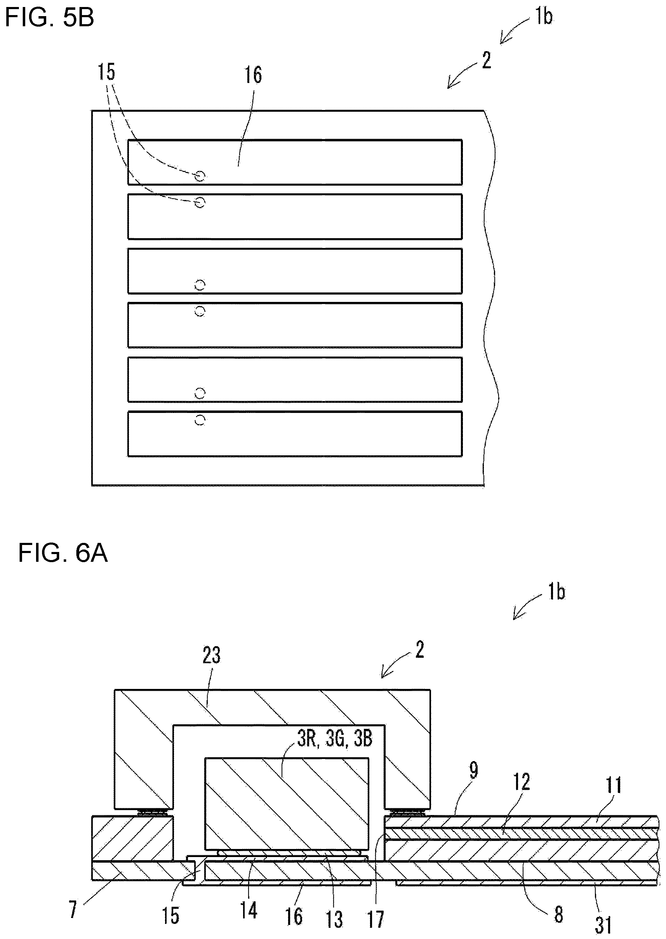

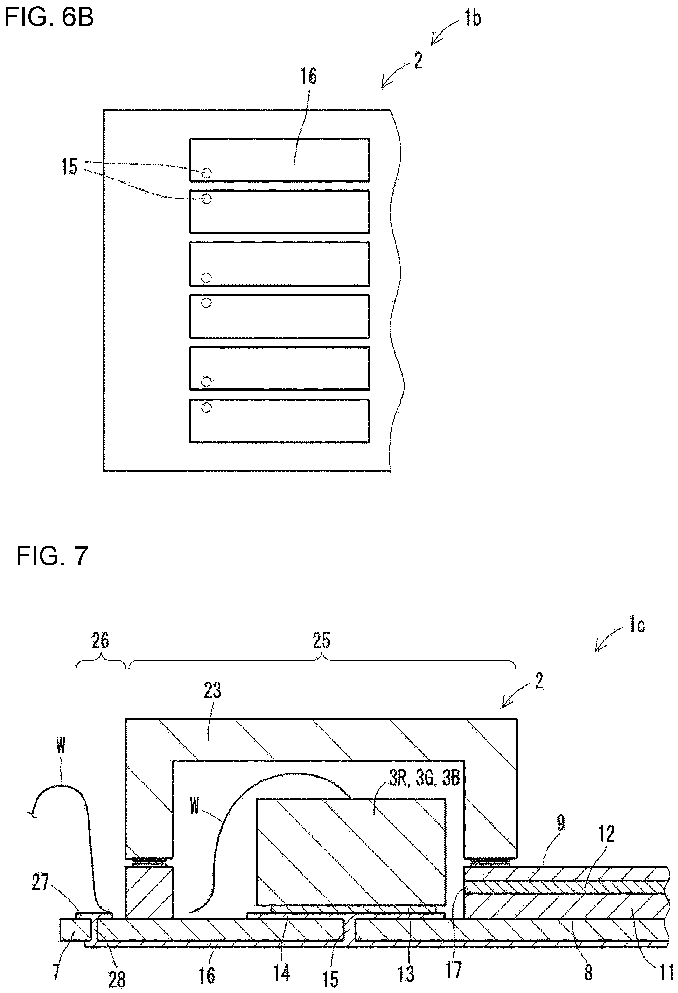

FIG. 5A is a cross-sectional view of a light-emitting device 1b according to an embodiment according to the claimed invention. FIG. 5B is a bottom view of the light-emitting device 1b. FIG. 6A is a cross-sectional view of a light-emitting device 1b with an example structure similar to the structure according to the fourth embodiment. FIG. 6B is a bottom view of the light-emitting device 1b. The same reference numerals denote the components corresponding to those in the above embodiments and will not be described repeatedly. In the light-emitting device 1b according to the present embodiment, second metal members 16 are larger than the first metal members 14 in a transparent bottom view as viewed through in a direction toward the fourth surface 9. In the present embodiment, the second metal members 16 are elongated in the longitudinal direction of the substrate 7 (the lateral direction in FIGs. 5A, 5B, 6A, and 6B). The second metal members 16 being longer and thus larger than the first metal members 14 simplifies secondary mounting to an external circuit and improves heat dissipation.

### Fifth Embodiment

FIG. 7 is a partial cross-sectional view of a light-emitting device 1c according to an embodiment not according to the claimed invention. The same reference numerals denote the components corresponding to those in the above embodiments and will not be described repeatedly. In the light-emitting device 1c according to the present embodiment, the second surface 6 includes a third area 25 inward from the outer periphery of the cladding 11 and a fourth area 26 other than the third area 25. Third metal members 27 are located in the fourth area 26. Each third metal member 27 is connected to the corresponding second metal member 16 with a second via conductor 28 extending through the substrate 7 from the first surface 5 to the second surface 6 of the substrate 7.

This structure allows formation of lead electrodes on the surface without separating the lid 23 and the cladding 11. The third metal members 27 on the external fourth area 26 may be easily connected to an external power supply with the wiring members W.

### Sixth Embodiment

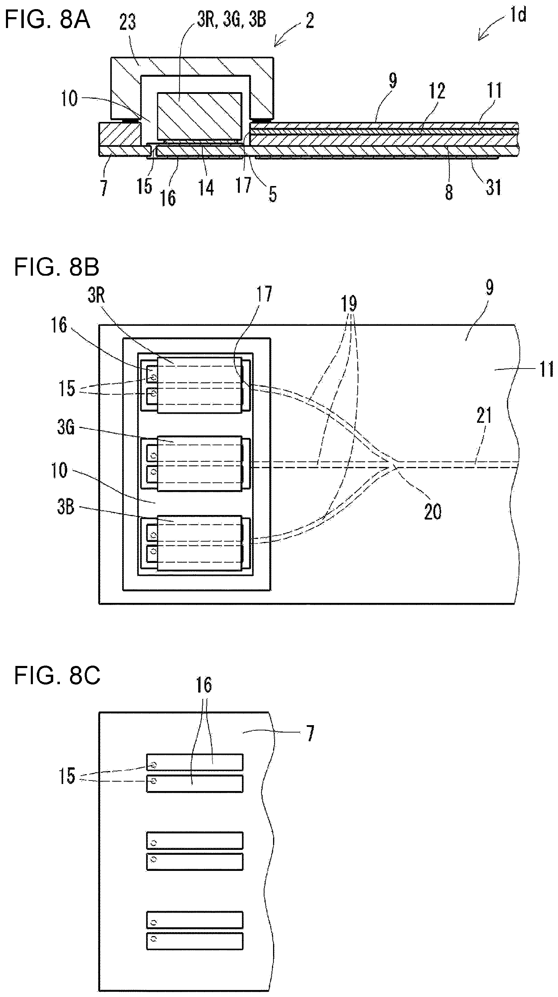

FIG. 8A is a cross-sectional view of a light-emitting device 1d according to an embodiment according to the claimed invention. FIG. 8B is a plan view of the light-emitting device 1d without the lid 23. FIG. 8C is a bottom view of the light-emitting device 1d. The same reference numerals denote the components corresponding to those in the above embodiments and will not be described repeatedly. In the light-emitting device 1d according to the present embodiment, first metal members 14 and second metal members 16 have the same shape and are plane symmetrical with respect to a plane parallel to the first surface 5. This structure has higher symmetry in the vertical direction in FIG. 8A in a side view and reduces deformation directly below the element mounts 13.

### Seventh Embodiment

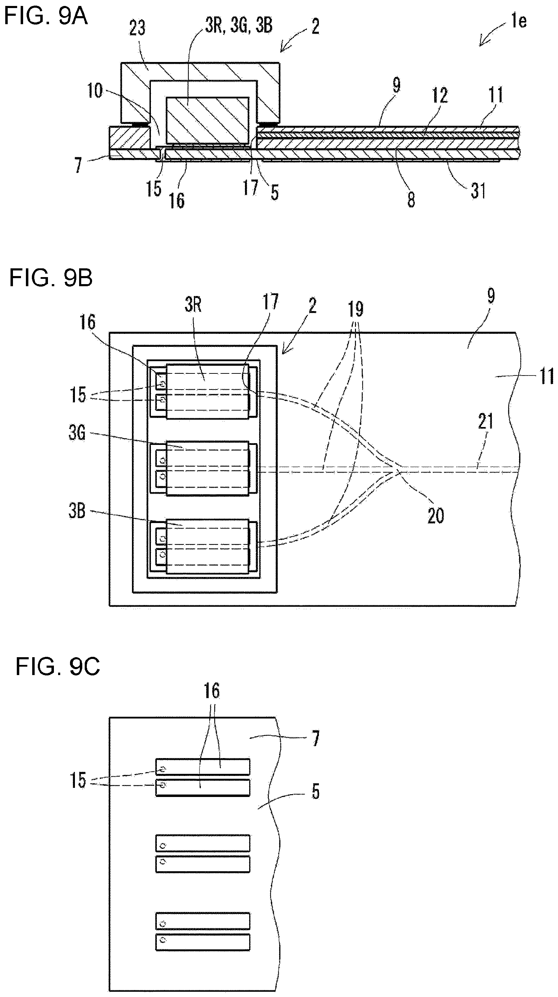

FIG. 9A is a cross-sectional view of a light-emitting device 1e according to an embodiment according to the claimed invention. FIG. 9B is a plan view of the light-emitting device 1e without the lid 23. FIG. 9C is a bottom view of the light-emitting device 1e. The same reference numerals denote the components corresponding to those in the above embodiments and will not be described repeatedly. **In** the light-emitting device 1e according to the present embodiment, second metal members 16 located on the first surface 5 include surfaces opposite to their surfaces facing the first surface 5 that are flat, or in other words, form a flat surface. This structure reduces tilt during secondary mounting, allows mounting of the light-emitting device 1e in a leveler state, and stabilizes secondary mounting to an external circuit.

### Eighth Embodiment

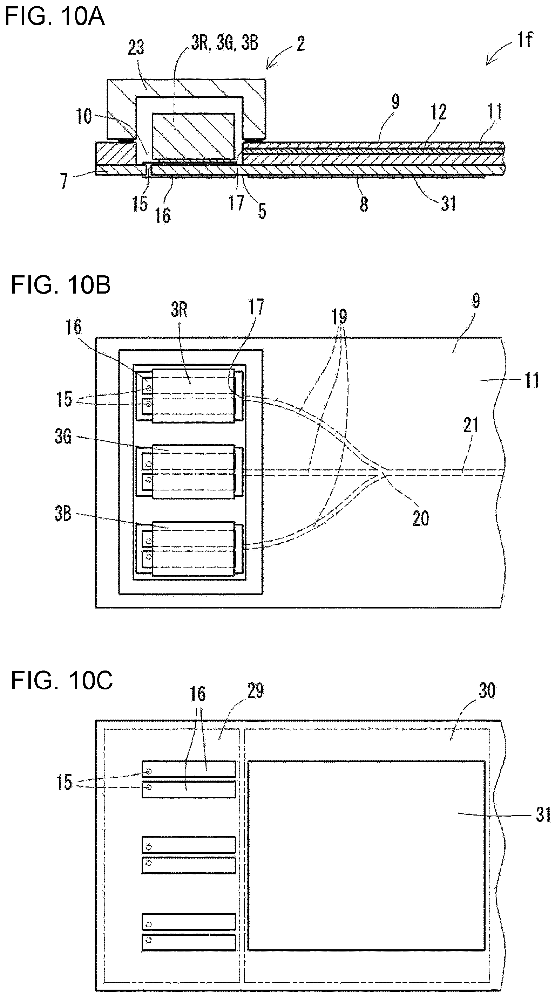

FIG. 10A is a cross-sectional view of a light-emitting device 1f according to an embodiment according to the claimed invention. FIG. 10B is a plan view of the light-emitting device 1f without the lid 23. FIG. 10C is a bottom view of the light-emitting device 1f. The same reference numerals denote the components corresponding to those in the above embodiments and will not be described repeatedly. **In** the light-emitting device 1f according to the present embodiment, second metal members 16 located on the first surface 5 include surfaces opposite to their surfaces facing the first surface 5 that are flat, or in other words, form a flat surface. The first surface 5 includes a fifth area 29 in which the second metal members 16 are located and a sixth area 30 other than the fifth area 29. A fourth metal member 31 is located on the sixth area 30. The fourth metal member 31 includes a surface opposite to its surface facing the first surface 5 that is flat similarly to the second metal members 16, or in other words, is formed on a common flat surface including the surfaces of the second metal members 16. This structure simplifies the manufacturing processes by allowing formation of the second metal members 16 and the fourth metal member 31 at the same time, and improves heat dissipation.

### Ninth Embodiment

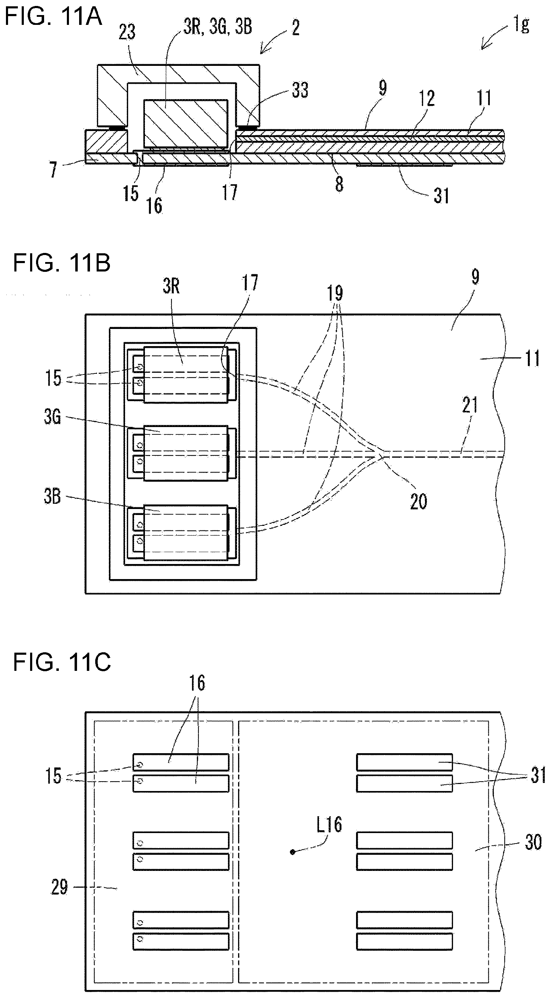

FIG. 11A is a cross-sectional view of a light-emitting device 1g according to an embodiment according to the claimed invention. FIG. 11B is a plan view of the light-emitting device 1g without the lid 23. FIG. 11C is a bottom view of the light-emitting device 1g. The same reference numerals denote the components corresponding to those in the above embodiments and will not be described repeatedly. In the light-emitting device 1g according to the present embodiment, the second metal members 16 are located on the first surface 5. The first surface 5 includes the fifth area 29 in which the second metal members 16 are located and the sixth area 30 other than the fifth area 29. Fourth metal members 31 are located in the sixth area 30. The second metal members 16 and the fourth metal members 31 are line symmetrical with respect to a central line L1 including the center of the first surface 5. This structure reduces asymmetric distribution of deformation with respect to the central line L1 due to higher temperatures of the second metal members 16 and the fourth metal members 31, and thus generates less thermal stress.

### Tenth Embodiment

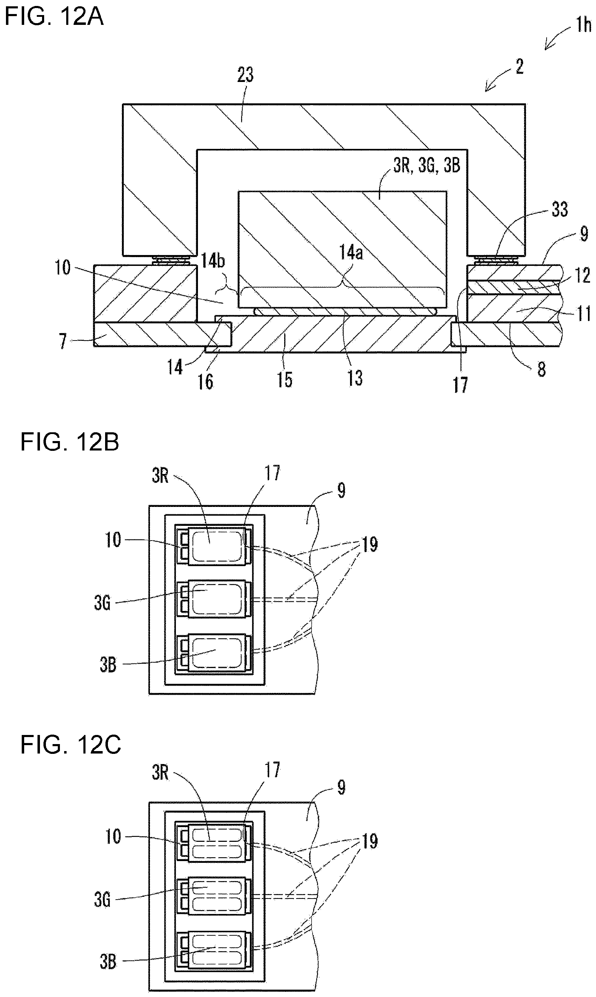

FIG. 12A is a cross-sectional view of a light-emitting device 1h according to an embodiment not according to the claimed invention. FIG. 12B is a plan view of the light-emitting device 1h without the lid 23. FIG. 12C is a bottom view of the light-emitting device 1h. The same reference numerals denote the components corresponding to those in the above embodiments and will not be described repeatedly. In the light-emitting device 1h according to the present embodiment, a contact area between each first via conductor 15 and the first metal member 14 is larger than or as large as the corresponding first area 14a. This structure increases the efficiency of heat transfer from the first metal members 14 located inside to the corresponding second metal members 16 located outside, and improves heat dissipation.

### Eleventh Embodiment

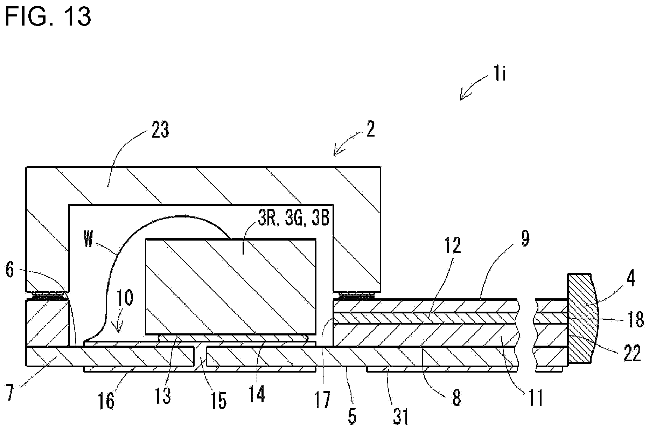

FIG. 13 is a cross-sectional view of a light-emitting device 1i according to an embodiment not according to the claimed invention. The same reference numerals denote the components corresponding to those in the above embodiments and will not be described repeatedly. In the present embodiment, the light-emitting device 1i includes the lid 23 sealing the element-receiving portion 10. The lid 23 can prevent unintended entry of external light through the incident end faces 17 of the core 12. With entry of unintended water and gas also being less likely, the light-emitting elements 3R, 3G, and 3B are less likely to corrode and thus can have longer service lives. The lid 23 with airtight sealing is particularly effective. With the lid 23 sealing the element-receiving portion 10, foreign matter such as objects suspended in the air are less likely to enter the element-receiving portion 10. This reduces objects that block traveling light in a space between the emission end of each light-emitting element 3R, 3G, or 3B and the corresponding incident end face 17 of the core 12.

### Twelfth Embodiment

In another example similar to the eleventh embodiment, a light-emitting device 1i includes a metal layer 33, which is, for example, a soldered bonding layer made of AuSn, SnAgCu, or another material, between the element-receiving portion 10 and the lid 23. The metal layer 33 airtightly joins the lid 23 and the cladding 11 together to seal the element-receiving portion 10 as described above.

In still another embodiment of the present disclosure, the light-emitting elements 3R, 3G, and 3B are not limited to light-emitting diodes (LEDs) but may be, for example, laser diodes (LDs) or vertical-cavity surface-emitting lasers (VCSELs).

### REFERENCE SIGNS

- 1, 1a to 1i: light-emitting device
- 2: optical waveguide package
- 3R, 3G, 3B: light-emitting element
- 4: condenser lens
- 5: first surface
- 6: second surface
- 7: substrate
- 8: third surface
- 9: fourth surface
- 10: element-receiving portion
- 11: cladding
- 12: core
- 13: element mount
- 14: first metal member
- 15: first via conductor
- 16: second metal member
- 17: incident end face
- 18: emission end face
- 19: branching path
- 20: merging portion
- 21: joined path
- 22: side surface
- 23: lid
- 25: third area
- 26: fourth area
- 27: third metal member
- 28: second via conductor
- 29: fifth area
- 30: sixth area
- 31: fourth metal member
- 33: metal layer

## Claims

1. An optical waveguide package (2), comprising:
a substrate (7) including a first surface (5) and a second surface (6) opposite to the first surface (5);
a cladding (11) on the second surface (6), the cladding (11) including a third surface (8) facing the second surface (6), a fourth surface (9) opposite to the third surface (8), and an element-receiving portion (10) with an opening in the fourth surface (9);
a core (12) in the cladding (11), the core (12) extending from the element-receiving portion (10); and
a first metal member (14) in the element-receiving portion (10) in a plan view as viewed in a direction toward the fourth surface (9), the first metal member (14) including an element mount (13),
wherein the first metal member (14) is connected to a second metal member (16) with a first via conductor (15) extending through the substrate (7) from the first surface (5) to the second surface (6),
wherein the first metal member (14) includes a first area (14a) being the element mount (13) and a second area (14b) other than the first area (14a),
**characterized in that**
the first via conductor (15) is in contact with the second area (14b) and located to avoid the first area (14a).

2. The optical waveguide package (2) according to claim 1, wherein
the element-receiving portion (10) extends from the fourth surface (9) to the third surface (8).

3. The optical waveguide package (2) according to claim 1 or 2, wherein
the first metal member (14) is located in the opening alone in the plan view.

4. The optical waveguide package (2) according to any one of claims 1 to 3, wherein
the second metal member (16) is larger than the first metal member (14) in a transparent plan view as viewed through in a direction toward the fourth surface (9).

5. The optical waveguide package (2) according to claim 4, wherein
the second surface (6) includes a third area (25) inward from an outer periphery of the cladding (11) and a fourth area (26) other than the third area (25),
the optical waveguide package (2) further includes a third metal member (27) located in the fourth area (26), and
the third metal member (27) is connected to the second metal member (16) with a second via conductor (28) extending through the substrate (7) from the first surface (5) to the second surface (6).

6. The optical waveguide package (2) according to any one of claims 1 to 3, wherein
the first metal member (14) and the second metal member (16) have a same shape and are plane symmetrical with respect to the first surface (5).

7. The optical waveguide package (2) according to any one of claims 1 to 6, wherein
the second metal member (16) is on the first surface (5), and the second metal member (16) includes a flat surface opposite to a surface facing the first surface (5).

8. The optical waveguide package (2) according to any one of claims 1 to 7, wherein
the second metal member (16) is on the first surface (5), and the second metal member (16) includes a surface opposite to a flat surface facing the first surface (5),
the first surface (5) includes a fifth area (29) in which the second metal member (16) is located and a sixth area (30) other than the fifth area (29),
the optical waveguide package (2) further includes a fourth metal member (31) in the sixth area (30), and
the fourth metal member (31) includes, similarly to the second metal member (16), a flat surface opposite to a surface facing the first surface (5).

9. The optical waveguide package (2) according to any one of claims 1 to 8, wherein
the second metal member (16) is on the first surface (5),
the first surface (5) includes a fifth area (29) in which the second metal member (16) is located and a sixth area (30) other than the fifth area (29),
the optical waveguide package (2) further includes a fourth metal member (31) in the sixth area (30), and
the second metal member (16) and the fourth metal member (31) are line symmetrical with respect to a central line (L1) including a center of the first surface (5).

10. The optical waveguide package (2) according to any one of claims 1 to 9, wherein
a contact area between the first via conductor (15) and the first metal member (14) is larger than or as large as the first area (14a).

11. The optical waveguide package (2) according to any one of claims 1 to 10, further comprising:
a lid (23) sealing the element-receiving portion (10).

12. The optical waveguide package (2) according to claim 11, further comprising:
a metal layer between the element-receiving portion (10) and the lid (23).

13. A light-emitting device (1), comprising:
the optical waveguide package (2) according to any one of claims 1 to 12;
a light-emitting element (3R, 3G, 3B) connected to the first metal member (14); and
a lens (4) on an optical path of light emitted from the core (12).

14. The light-emitting device (1) according to claim 13, wherein
the lid (23) includes a recess, and
the light-emitting element (3R, 3G, 3B) extends from the element-receiving portion (10) into the recess.

## Patentansprüche

1. Lichtwellenleitergehäuse (2), aufweisend:
ein Substrat (7) aufweisend eine erste Fläche (5) und eine zu der ersten Fläche (5) entgegengesetzte zweite Fläche (6);
eine Verkleidung (11) auf der zweiten Fläche (6), wobei die Verkleidung (11) eine der zweiten Fläche (6) zugewandte dritte Fläche (8), eine zu der dritten Fläche (8) entgegengesetzte vierte Fläche (9) und einen Elementaufnahmeabschnitt (10) mit einer Öffnung in der vierten Fläche (9) aufweist;
einen Kern (12) in der Verkleidung (11), wobei sich der Kern (12) von dem Elementaufnahmeabschnitt (10) aus erstreckt; und
ein erstes Metallelement (14) in dem Elementaufnahmeabschnitt (10) in einer Draufsicht betrachtet in einer Richtung zu der vierten Fläche (9), wobei das erste Metallelement (14) eine Elementhalterung (13) aufweist,
wobei das erste Metallelement (14) mit einem zweiten Metallelement (16) verbunden ist, wobei sich ein erster Durchkontaktierungsleiter (15) durch das Substrat (7) hindurch von der ersten Fläche (5) zu der zweiten Fläche (6) erstreckt,
wobei das erste Metallelement (14) einen ersten Bereich (14a), der die Elementhalterung (13) ist, und einen zweiten Bereich (14b) aufweist, der von dem ersten Bereich (14a) verschieden ist,
**dadurch gekennzeichnet, dass**
der erste Durchkontaktierungsleiter (15) mit dem zweiten Bereich (14b) in Kontakt ist und angeordnet ist, um den ersten Bereich (14a) zu vermeiden.

2. Lichtwellenleitergehäuse (2) gemäß Anspruch 1, wobei
sich der Elementaufnahmeabschnitt (10) von der vierten Fläche (9) zur dritten Fläche (8) erstreckt.

3. Lichtwellenleitergehäuse (2) gemäß Anspruch 1 oder 2, wobei
das erste Metallelement (14) in der Draufsicht allein in der Öffnung angeordnet ist.

4. Lichtwellenleitergehäuse (2) gemäß irgendeinem der Ansprüche 1 bis 3, wobei
das zweite Metallelement (16) in einer transparenten Draufsicht, hindurchbetrachtet in einer Richtung zu der vierten Fläche (9) hin, größer als das erste Metallelement (14) ist.

5. Lichtwellenleitergehäuse (2) gemäß Anspruch 4, wobei
die zweite Fläche (6) einen dritten Bereich (25) von einem Außenumfang der Verkleidung (11) nach innen und einen vierten Bereich (26) aufweist, der von dem dritten Bereich (25) verschieden ist,
das Lichtwellenleitergehäuse (2) ferner ein drittes Metallelement (27) aufweist, das in dem vierten Bereich (26) angeordnet ist, und
das dritte Metallelement (27) mit dem zweiten Metallelement (16) verbunden ist, wobei sich ein zweiter Durchkontaktierungsleiter (28) von der ersten Fläche (5) zu der zweiten Fläche (6) durch das Substrat (7) hindurch erstreckt.

6. Lichtwellenleitergehäuse (2) gemäß irgendeinem der Ansprüche 1 bis 3, wobei
das erste Metallelement (14) und das zweite Metallelement (16) eine gleiche Form haben und in Bezug auf die erste Fläche (5) flächensymmetrisch sind.

7. Lichtwellenleitergehäuse (2) gemäß irgendeinem der Ansprüche 1 bis 6, wobei
das zweite Metallelement (16) auf der ersten Fläche (5) ist und das zweite Metallelement (16) eine flache Fläche aufweist, die zu einer der ersten Fläche (5) zugewandten Fläche entgegengesetzt ist.

8. Lichtwellenleitergehäuse (2) gemäß irgendeinem der Ansprüche 1 bis 7, wobei
das zweite Metallelement (16) auf der ersten Fläche (5) ist und das zweite Metallelement (16) eine Fläche aufweist, die zu einer der ersten Fläche (5) zugewandten flachen Fläche entgegengesetzt ist,
die erste Fläche (5) einen fünften Bereich (29), in dem das zweite Metallelement (16) angeordnet ist, und einen sechsten Bereich (30) aufweist, der von dem fünften Bereich (29) verschieden ist,
das Lichtwellenleitergehäuse (2) ferner ein viertes Metallelement (31) in dem sechsten Bereich (30) aufweist, und
das vierte Metallelement (31) ähnlich wie das zweite Metallelement (16) eine flache Fläche aufweist, die zu einer der ersten Flächen (5) zugewandten Fläche entgegengesetzt ist.

9. Lichtwellenleitergehäuse (2) gemäß irgendeinem der Ansprüche 1 bis 8, wobei
das zweite Metallelement (16) auf der zweiten Fläche (5) ist,
die zweite Fläche (5) einen fünften Bereich (29), in dem das zweite Metallelement (16) angeordnet ist, und einen sechsten Bereich (30) aufweist, der von dem fünften Bereich (29) verschieden ist,
das Lichtwellenleitergehäuse (2) ferner ein viertes Metallelement (31) in dem sechsten Bereich (30) aufweist, und
das zweite Metallelement (16) und das vierte Metallelement (31) in Bezug auf eine Mittellinie (L1), die einen Mittelpunkt der zweiten Fläche (5) enthält, liniensymmetrisch sind.

10. Lichtwellenleitergehäuse (2) gemäß irgendeinem der Ansprüche 1 bis 9, wobei
ein Kontaktbereich zwischen dem ersten Durchkontaktierungsleiter (15) und dem ersten Metallelement (14) größer oder genauso groß wie der erste Bereich (14a) ist.

11. Lichtwellenleitergehäuse (2) gemäß irgendeinem der Ansprüche 1 bis 10, ferner aufweisend:
einen Deckel (23), der den Elementaufnahmeabschnitt (10) abdichtet.

12. Lichtwellenleitergehäuse (2) gemäß Anspruch 11, ferner aufweisend:
eine Metallschicht zwischen dem Elementaufnahmeabschnitt (10) und dem Deckel (23).

13. Lichtemittierende Vorrichtung (1), aufweisend:
das Lichtwellenleitergehäuse (2) gemäß irgendeinem der Ansprüche 1 bis 12;
ein lichtemittierendes Element (3R, 3G, 3B), das mit dem ersten Metallelement (14) verbunden ist; und
eine Linse (4) auf einem Strahlengang von von dem Kern (12) emittierten Licht.

14. Lichtemittierende Vorrichtung (1) gemäß Anspruch 13, wobei
der Deckel (23) eine Aussparung aufweist und
sich das lichtemittierende Element (3R, 3G, 3B) von dem Elementaufnahmeabschnitt (10) in die Aussparung erstreckt.

## Revendications

1. Boîtier de guide d'onde optique (2), comprenant :
un substrat (7) comportant une première surface (5) et une deuxième surface (6) opposée à la première surface (5) ;
une gaine (11) sur la deuxième surface (6), la gaine (11) comportant une troisième surface (8) faisant face à la deuxième surface (6), une quatrième surface (9) opposée à la troisième surface (8), et une partie de réception d'élément (10) comportant une ouverture dans la quatrième surface (9) ;
un cœur (12) dans la gaine (11), le cœur (12) s'étendant à partir de la partie de réception d'élément (10) ; et
un premier élément métallique (14) dans la partie de réception d'élément (10) en une vue en plan telle que vue dans une direction vers la quatrième surface (9), le premier élément métallique (14) comprenant un support d'élément (13),
dans lequel le premier élément métallique (14) est relié à un deuxième élément métallique (16) par l'intermédiaire d'un premier conducteur de via (15) s'étendant à travers le substrat (7) depuis la première surface (5) jusqu'à la deuxième surface (6),
dans lequel le premier élément métallique (14) comprend une première zone (14a) étant le support d'élément (13) et une deuxième zone (14b) autre que la première zone (14a),
**caractérisé en ce que**
le premier conducteur de via (15) est en contact avec la deuxième zone (14b) et est situé de manière à éviter la première zone (14a).

2. Boîtier de guide d'onde optique (2) selon la revendication 1, dans lequel
la partie de réception d'élément (10) s'étend de la quatrième surface (9) à la troisième surface (8).

3. Boîtier de guide d'onde optique (2) selon la revendication 1 ou 2, dans lequel
le premier élément métallique (14) est situé uniquement dans l'ouverture en vue en plan.

4. Boîtier de guide d'onde optique (2) selon l'une quelconque des revendications 1 à 3, dans lequel
le deuxième élément métallique (16) est plus grand que le premier élément métallique (14) dans une vue en plan transparente, telle que vue à travers dans une direction vers la quatrième surface (9).

5. Boîtier de guide d'onde optique (2) selon la revendication 4, dans lequel
la deuxième surface (6) comprend une troisième zone (25) située vers l'intérieur à partir d'une périphérie extérieure de la gaine (11) et une quatrième zone (26) autre que la troisième zone (25),
le boîtier de guide d'onde optique (2) comprend en outre un troisième élément métallique (27) situé dans la quatrième zone (26), et
le troisième élément métallique (27) est relié au deuxième élément métallique (16) avec un deuxième conducteur de via (28) s'étendant à travers le substrat (7) de la première surface (5) à la deuxième surface (6).

6. Boîtier de guide d'onde optique (2) selon l'une quelconque des revendications 1 à 3, dans lequel
le premier élément métallique (14) et le deuxième élément métallique (16) ont une même forme et sont symétriques en plan par rapport à la première surface (5).

7. Boîtier de guide d'onde optique (2) selon l'une quelconque des revendications 1 à 6, dans lequel
le deuxième élément métallique (16) est sur la première surface (5), et le deuxième élément métallique (16) comprend une surface plane opposée à une surface faisant face à la première surface (5).

8. Boîtier de guide d'onde optique (2) selon l'une quelconque des revendications 1 à 7, dans lequel
le deuxième élément métallique (16) est sur la première surface (5), et le deuxième élément métallique (16) comprend une surface opposée à une surface plane faisant face à la première surface (5),
la première surface (5) comprend une cinquième zone (29) dans laquelle se trouve le deuxième élément métallique (16) et une sixième zone (30) autre que la cinquième zone (29),
le boîtier de guide d'onde optique (2) comprend en outre un quatrième élément métallique (31) dans la sixième zone (30), et
le quatrième élément métallique (31) comprend, de manière similaire au deuxième élément métallique (16), une surface plane opposée à une surface faisant face à la première surface (5).

9. Boîtier de guide d'onde optique (2) selon l'une quelconque des revendications 1 à 8, dans lequel
le deuxième élément métallique (16) se trouve sur la première surface (5),
la première surface (5) comprend une cinquième zone (29) dans laquelle se trouve le deuxième élément métallique (16) et une sixième zone (30) autre que la cinquième zone (29),
le boîtier de guide d'onde optique (2) comprend en outre un quatrième élément métallique (31) dans la sixième zone (30), et
le deuxième élément métallique (16) et le quatrième élément métallique (31) sont symétriques en ligne par rapport à une ligne centrale (L1) comprenant un centre de la première surface (5).

10. Boîtier de guide d'onde optique (2) selon l'une quelconque des revendications 1 à 9, dans lequel
une zone de contact entre le premier conducteur de via (15) et le premier élément métallique (14) est plus grande ou aussi grande que la première zone (14a).

11. Boîtier de guide d'onde optique (2) selon l'une quelconque des revendications 1 à 10, comprenant en outre :
un couvercle (23) scellant la partie de réception d'élément (10).

12. Boîtier de guide d'onde optique (2) selon la revendication 11, comprenant en outre :
une couche métallique entre la partie de réception d'élément (10) et le couvercle (23).

13. Dispositif électroluminescent (1), comprenant :
le boîtier de guide d'onde optique (2) selon l'une quelconque des revendications 1 à 12 ;
un élément électroluminescent (3R, 3G, 3B) connecté au premier élément métallique (14) ; et
une lentille (4) sur un trajet optique de lumière émise depuis le cœur (12).

14. Dispositif électroluminescent (1) selon la revendication 13, dans lequel
le couvercle (23) comprend un évidement, et
l'élément électroluminescent (3R, 3G, 3B) s'étend depuis la partie de réception d'élément (10) dans l'évidement.
